# EUROPÄISCHE PATENTSCHRIFT

(11) **EP 3 048 426 B1**
(45) Veröffentlichungstag und Bekanntmachung des Hinweises auf die Patenterteilung: **13.09.2017**
(21) Anmeldenummer: 15191806.7
(22) Anmeldetag: 28.10.2015
(51) Int. Cl.: G01D 5/34, G01D 5/347, G01B 5/008, G01B 11/14, G03F 7/20

(54) **POSITIONSMESSEINRICHTUNG**
POSITION MEASUREMENT DEVICE
DISPOSITIF DE MESURE DE POSITION

(30) Priorität: 26.01.2015 DE 102015201230
(43) Veröffentlichungstag der Anmeldung: 27.07.2016
(73) Patentinhaber: Dr. Johannes Heidenhain GmbH, 83301 Traunreut (DE)
(72) Erfinder: SPECKBACHER, Peter, 84558 Kirchweidach (DE); GRÜNDL, Tobias, 83734 Hausham (DE); WEIDMANN, Josef, 84550 Feichten a.d. Alz (DE); GRAHAM, Andrew, 83339 Chieming (DE); BAYER, Daniela, 83365 Nußdorf (DE)

(56) Entgegenhaltungen:
- EP-A1- 0 610 833
- EP-A1- 2 051 047
- EP-A2- 2 395 328
- EP-A2- 2 511 669
- US-A1- 2013 112 860

## Beschreibung

### GEBIET DER TECHNIK

Die Erfindung betrifft eine Positionsmesseinrichtung zur Positionsmessung in zumindest einer Richtung.

Eine derartige Positionsmesseinrichtung wird zur Messung von Lageänderungen zweier relativ zueinander beweglicher Objekte eingesetzt. Ein Maßstab wird dabei von einem Lichtbündel abgetastet und das an dem Maßstab positionsabhängig modulierte Lichtbündel wird einer Abtasteinrichtung zugeführt, welche daraus ein Maß für die Momentanposition der Abtasteinrichtung gegenüber dem Maßstab bildet.

Zur Messung relativ großer Längen werden mehrere Maßstäbe aneinander gereiht und die mehreren Maßstäbe werden nacheinander von der Abtasteinrichtung abgetastet. Eine derartige Anforderung ist insbesondere beim Einsatz der Positionsmesseinrichtung in Lithografie-Systemen gegeben, da einerseits die erreichbaren Messschritte immer kleiner werden sollen und - bedingt durch die immer größer werdenden Wafer - die geforderten Messwege immer größer werden. Bedingt durch die höheren Genauigkeitsanforderungen von neuen Lithografie-Systemen und die Entwicklung zu größeren Wafern hin müssen die Messwege immer positionsgenauer und immer größer werden.

### STAND DER TECHNIK

Die gattungsbildende EP 1 762 897 A1 zeigt eine Positionsmesseinrichtung mit mehreren Maßstäben in einem Lithografie-System, die zur Vergrößerung des Messbereiches aneinander gereiht sind. Die mehreren Maßstäbe weisen jeweils reflektierende Phasengitter auf. Die Maßstäbe sind an einem Träger (metrology frame) derart angeordnet, dass über den Stoß zweier Maßstäbe hinweg eine kontinuierliche Positionsmessung ermöglicht ist. Die Abtasteinrichtung ist dazu ausgebildet um eine kontinuierliche Positionsmessung über den Stoß hinweg zu ermöglichen. Die Maßstäbe werden in der EP 1 762 897 A1 als Gitterplatten (grid plates) bezeichnet und sind zur Positionsmessung in zwei senkrecht zueinander angeordneten Richtungen ausgebildet.

Es ist bekannt, dass die Beugungseffizienz eines reflektierenden Phasengitters durch eine Vielzahl von Parametern beeinflusst werden kann.

Die relative Beugungseffizienz wird beeinflusst durch die Form der Phasenstufen. Parameter für die Form sind das Profil der Phasenstufen - insbesondere der Flankenwinkel - und die Außenkontur der reflektierenden Flächen der Phasenstufen.

Aus der EP 0 849 567 B1 ist bekannt, dass die Beugungseffizienz eines reflektierenden Phasengitters durch geeignete Wahl des Profils der Phasenstufen optimiert werden kann. Durch geeignete Wahl des Flankenwinkels kann die relative Beugungseffizienz optimiert werden.

In der EP 1106972 A1 ist offenbart, dass die Außenkontur der Markierungen eines Phasengitters eines Maßstabs rechteckförmig sein kann, wobei die reflektierenden Rechtecke in Form eines Schachbrett-Musters mit angrenzenden Ecken zweidimensional angeordnet sind. Weiterhin ist allgemein angegeben, dass die Markierungen alternativ auch kreisringförmig ausgebildet sein können.

Die EP 2 051 047 A1 offenbart, dass die Beugungseffizienz eines reflektierenden Phasengitters durch geeignete Wahl der Stufenhöhe in Abhängigkeit der Licht-Wellenlänge optimiert werden kann.

In der US 2013/0112860 A1 wird aufgezeigt, dass die Beugungseffizienz eines Phasengitters durch die Stufenhöhe sowie durch unterschiedliche Reflelstivitäten in den erhabenen Bereichen und den abgestuften Bereichen einer periodischen Markierung optimiert werden kann.

### ZUSAMMENFASSUNG DER ERFINDUNG

Der Erfindung liegt die Aufgabe zugrunde eine Positionsmesseinrichtung zu schaffen, mit der eine präzise Positionsmessung über einen großen Messbereich ermöglicht wird.

Man unterscheidet zwischen der absoluten Beugungseffizienz eines reflektierenden Phasengitters, oft auch nur Beugungseffizienz genannt, und der relativen Beugungseffizienz.

Ein wesentlicher Parameter für die Beugungseffizienz eines reflektierenden Phasengitters eines Maßstabs ist die Form der Phasenstufen. Form bedeutet dabei die Form des Höhenprofils einer Phasenstufe und die Außenkontur der reflektierenden Oberfläche der Phasenstufen des Phasengitters.

Ein weiterer wesentlicher Parameter ist die Reflektivität des Phasengitters, die abhängig ist von der Reflektivität der verwendeten Reflektoren.

Beide Parameter Form und Reflektivität bestimmen die Beugungseffizienz eines Phasengitters, die auch absolute Beugungseffizienz genannt wird. Die Beugungseffizienz eines Phasengitters ist das Verhältnis der Intensität zwischen einem in einen bestimmten Raumwinkel (Beugungsordnung) gebeugten Lichtbündels zu der auf das Phasengitter einfallenden Intensität eines Lichtbündels einer bestimmten Wellenlänge.

Wird nur die geometrische Form der Phasenstufen berücksichtigt (die geometrische Außenkontur und das Profil der Phasenstufen, insbesondere der Flankenwinltel), bei identischer Reflektivität der verwendeten Materialien als Referenz, so spricht man von der relativen Beugungseffizienz.

Wie der eingangs genannte Stand der Technik zeigt, wurde die Form des Phasengitters immer mehr optimiert um die relative Beugungseffizienz zu erhöhen. Für viele Applikationen stehen nun neue optimierte Maßstäbe zur Verfügung, die eine höhere Beugungseffizienz aufweisen wie die bisher eingesetzten Maßstäbe. Oft hat der Hersteller der Maßstäbe bei seiner Fertigung auf die optimierten Maßstäbe mit optimierter Form des Phasengitters umgestellt.

Besteht nun bei einer existierenden Positionsmesseinrichtung das Erfordernis einen der mehreren Maßstäbe auszutauschen ergibt sich ein Problem. Aufgrund der höheren relativen Beugungseffizienz des neuen Maßstabs aufgrund der optimierten Form des Phasengitters resultiert bei der Abtastung des neuen Maßstabs ein größeres Abtastsignal gegenüber der Abtastung der älteren Maßstäbe, was Probleme bei der weiteren Auswertung mit sich bringen kann.

Mit der Erfindung wird erreicht, dass ein Maßstab mit optimierter Form des Phasengitters, also mit hoher relativer Beugungseffizienz, als Ersatz für einen Maßstab der Positionsmesseinrichtung verwendet werden kann, wobei dieser Ersatz-Maßstab an die Beugungseffizienz der verbliebenen Maßstäbe angepasst ist, indem seine Reflektivität verringert ist.

Reflektivität bedeutet dabei das Verhältnis reflektierter und einfallender Intensität eines Lichtbündels unabhängig von der Form des Phasengitters.

Gemäß der Erfindung weist die Positionsmesseinrichtung zumindest einen ersten Maßstab und zumindest einen zweiten Maßstab auf, die zur Vergrößerung des Messbereichs aneinander gereiht sind. Weiterhin umfasst die Positionsmesseinrichtung eine Abtasteinrichtung mit einer Lichtquelle zum Aussenden eines Lichtbündels, wobei der erste Maßstab ein reflektierendes Phasengitter mit ersten periodischen Markierungen aufweist, welche ein auftreffendes Lichtbündel mit einer ersten Beugungseffizienz in eine vorgegebene Beugungsordnung beugt. Der zweite Maßstab weist ein reflektierendes Phasengitter mit zweiten periodischen Markierungen auf, deren Form von den ersten periodischen Markierungen abweicht. Die Beugungseffizienz einer vorgegebenen Beugungsordnung des zweiten Maßstabs wird an die Beugungseffizienz des ersten Maßstabs angepasst, indem die Reflektivität des Phasengitters des zweiten Maßstabs gegenüber der Reflektivität des Phasengitters des ersten Maßstabs verringert ist.

Bedingt durch die optimierte und somit andersartige Form der Markierungen des zweiten Maßstabs ist die relative Beugungseffizienz des zweiten Maßstabs höher als die relative Beugungseffizienz des ersten Maßstabs.

### KURZE BESCHREIBUNG DER ZEICHNUNGEN

Es zeigt
- Figur 1: eine Positionsmesseinrichtung gemäß der Erfindung im Schnitt;
- Figur 2: einen Draufsicht des ersten Maßstabs der Positionsmesseinrichtung gemäß Figur 1;
- Figur 3: eine Draufsicht des zweiten Maßstabs der Positionsmesseinrichtung gemäß Figur 1;
- Figur 4: eine Draufsicht eines weiteren Ausführungsbeispiels des zweiten Maßstabs, und
- Figur 5: einen Schnitt V-V des zweiten Maßstabs gemäß Figur 4.

### BESCHREIBUNG DER AUSFÜHRUNGSFORMEN

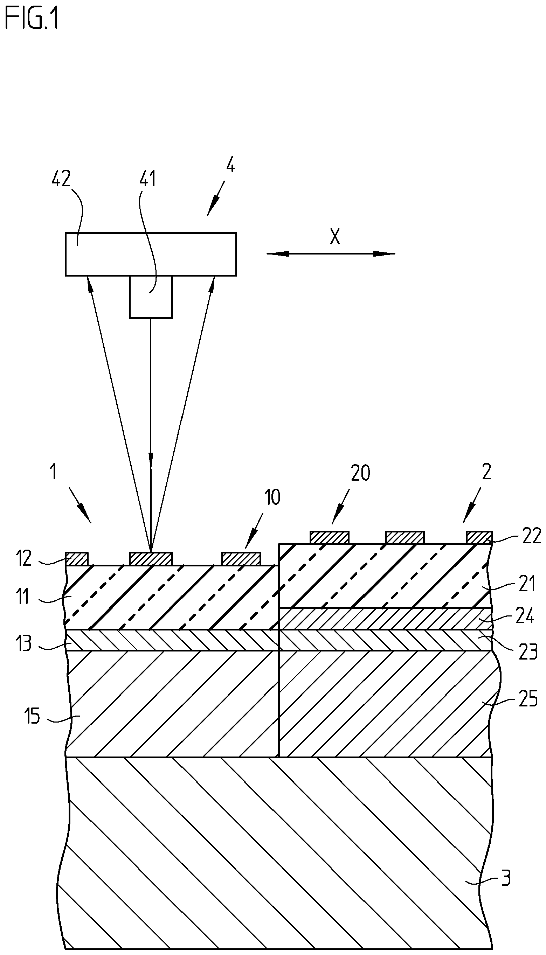

In der Figur 1 sind schematisch die wesentlichen Elemente der Positionsmesseinrichtung dargestellt. Diese Positionsmesseinrichtung umfasst zumindest einen ersten Maßstab 1 und zumindest einen zweiten Maßstab 2, die zur Vergrößerung des Messbereichs in zumindest einer Messrichtung X aneinander gereiht sind. Die Aneinanderreihung der Maßstäbe 1, 2 erfolgt deshalb, da physikalisch bedingt ein Maßstab 1, 2 mit hoher Auflösung und hoher Genauigkeit nur in eingeschränkter Größe gefertigt werden kann. Die Positionsmessung im Nanometer- oder Subnanometer-Bereich wird insbesondere in Lithografie-Systemen gefordert, wobei hierzu die Maßstäbe 1, 2 periodische Markierungen 10, 20 kleiner 10 µm aufweisen. Die Markierungen 10, 20 sind Phasenstufen mit einer bestimmten Form, also mit bestimmter Profilform und bestimmter Außenkontur der oberen reflektierenden Fläche. Die obere refllektierende Fläche bildet jeweils zusammen mit dem unteren Reflektor 13, 23 sowie der Abstandsschicht 11, 21 das Phasengitter. Durch die Aneinanderreihung mehrerer Maßstäbe 1, 2 in Messrichtung X ist eine kontinuierliche Positionsmessung über den Stoß zweier Maßstäbe 1, 2 hinweg möglich. Besonders vorteilhaft ist es, wenn die Maßstäbe 1, 2 in gleicher Ebene aneinander gestoßen sind. Darüber hinaus sind die Maßstäbe 1, 2 auf einem gemeinsamen Träger 3 angeordnet, wobei der Träger 3 auch metrology frame genannt wird.

Zur lichtelektrischen Abtastung der Maßstäbe 1, 2 ist eine Abtasteinrichtung 4 vorgesehen, welche eine Lichtquelle 41 zum Aussenden eines Lichtbündels aufweist, welches bei der Positionsmessung auf einen der Maßstäbe 1, 2 trifft und dort gebeugt wird. Die Abtasteinrichtung 4 umfasst weiterhin eine Empfangseinheit 42 zum Empfang des gebeugten Lichtbündels. In der Figur 1 ist die Empfangseinheit 42 für die Messrichtung X nur schematisch dargestellt.

Die ersten periodischen Markierungen 10 des ersten Maßstabs 1 bilden mit den Reflektoren 12, 13 und der Abstandsschicht 11 das Phasengitter, welches das auftreffende Lichtbündel mit einer ersten Beugungseffizienz in eine vorgegebene Beugungsordnung beugt.

Der zweite Maßstab 2 bildet ein reflektierendes Phasengitter mit den zweiten periodischen Markierungen 20, deren Form von den ersten periodischen Markierungen 10 derart abweicht, dass die relative Beugungseffizienz des zweiten Maßstabs 2 höher ist als die relative Beugungseffizienz des ersten Maßstabs 1.

Als Substrat 15 für das erste Phasengitter und als Substrat 25 für das zweite Phasengitter wird vorzugsweise ein Material mit geringem thermischen Ausdehnungskoeffizienten, insbesondere Glas, Glaskeramik oder Aluminiumoxidkeramik (Cordierite) verwendet. Derartige Materialien sind auch unter den Namen ZERODUR, ULE oder NEXCERA bekannt.

Die Reflektivität des zweiten Maßstabs 2 ist gegenüber der Reflektivität des ersten Maßstabs 1 derart verringert, dass der zweite Maßstab 2 das auftreffende Lichtbündel mit der gleichen Beugungseffizienz wie der erste Maßstab 1 in die vorgegebene Beugungsordnung beugt. Die Beugungseffizienz des zweiten Maßstabs 2 wird somit an die Höhe der Beugungseffizienz des ersten Maßstabs 1 angepasst.

Bei optimierter Form der Markierungen 20 des zweiten Maßstabs 2 gegenüber dem ersten Maßstab 1 ist es erforderlich, dass die Reflektivität des zweiten Maßstabs 2 gegenüber dem ersten Maßstab 1 um 5 % bis 20 % verringert ist.

In vorteilhafter Weise ist das Phasengitter des ersten Maßstabs 1 und das Phasengitter des zweiten Maßstabs 2 jeweils dazu ausgebildet, die nullte Beugungsordnung zu unterdrücken, wobei die auszuwertende und damit die vorgegebene Beugungsordnung die erste Beugungsordnung ist.

Das Phasengitter des ersten Maßstabs 1 und das Phasengitter des zweiten Maßstabs 2 weisen jeweils einen Schichtstapel auf, bestehend aus einer transparenten Abstandsschicht 11, 21 und zwei Reflektoren 12, 13, 22, 23, die jeweils zu beiden Seiten der Abstandsschicht 11, 21 angeordnet sind, wobei der der Abtasteinrichtung 4 zugewandte Reflektor 12 des ersten Maßstabs 1 die ersten periodischen Markierungen 10 bildet und der der Abtasteinrichtung 4 zugewandte Reflektor 22 des zweiten Maßstabs 2 die zweiten periodischen Markierungen 20 bildet.

Die transparente Abstandsschicht 11, 21 besteht vorzugsweise jeweils aus dielektrischem Material wie z. B. SiO₂, TiO₂, Ta₂O₅ und bildet den Phasenschieber für die vorgegebene Beugungsordnung.

Bei einem erforderlichen Wechsel eines Maßstabs 1 der Positionsmesseinrichtung, bei der mehrere erste Maßstäbe 1 vorhanden sind, wird gemäß der Erfindung ein zweiter Maßstab 2 eingesetzt, bei dem die relative Beugungseffizienz gegenüber den verbliebenen ersten Maßstäben 1 größer ist, aber die (absolute) Beugungseffizienz angepasst ist an die Beugungseffizienz der ersten Maßstäbe 1.

Als besonders vorteilhaft hat sich erwiesen, wenn die Reflektivität des zweiten Maßstabs 2 dadurch verringert wird, dass das den Phasenhub erzeugende Schichtenpaket bestehend aus der Abstandsschicht 21 und dem Reflektor 22 vom ersten Maßstab 1 unverändert übernommen wird. Unverändert übernommen bedeutet dabei Material und Dicke. Es hat sich gezeigt, dass als Parameter der anzupassen ist die Reflektivität des Reflektors 23 unter der Abstandsschicht 21 des zweiten Maßstabs 2 besonders geeignet ist.

Die Reflektivität des zweiten Maßstabs 2 wird in vorteilhafter Weise kleiner gewählt als die Reflektivität des ersten Maßstabs 1, indem die Reflektivität des Reflektors 23 unter der Abstandsschicht 21 des zweiten Maßstabs 2 kleiner gewählt wird als die Reflektivität des Reflektors 13 unter der Abstandsschicht 11 des ersten Maßstabs 1. Die Reflektivität kann durch geeignete Wahl des Materials oder durch Veränderung der Oberfläche des Reflektors 23 angepasst werden.

Als besonders vorteilhaft hat sich herausgestellt, wenn die Reflektivität des zweiten Maßstabs 2 gegenüber dem ersten Maßstab 1 verringert wird, indem zwischen der Abstandsschicht 21 und des Reflektors 23, welcher unter der Abstandsschicht 21 des zweiten Maßstabs 2 angeordnet ist eine Dämpfungsschicht 24 angeordnet ist. Dies hat den Vorteil, dass der bewährte Schichtaufbau des ersten Maßstabs 1 übernommen werden kann, mit den bewährten Eigenschaften des Phasenhubs. Verfahrenstechnisch ist nur erforderlich, dass zwischen dem Reflektor 23 und der Abstandsschicht 21 des zweiten Maßstabs 2 die Dämpfungsschicht 24 zur Verringerung der Reflektivität einzubringen ist.

Die Dämpfungsschicht 24 ist eine teiltransparente Schicht, insbesondere eine dünne Metallschicht, z.B. aufweisend Chrom, Nickel, Titan oder Silizium mit der Dicke von einigen nm, insbesondere im Bereich von 3 nm bis 15 nm.

Die Erfindung ist besonders vorteilhaft bei einer Positionsmesseinrichtung einsetzbar, die zur Positionsmessung in zwei senkrecht zueinander angeordneten Richtungen X, Y ausgebildet ist. Dabei ist der erste Maßstab 1 und der zweite Maßstab 2 jeweils zur Positionsmessung in den zwei senkrecht zueinander angeordneten Richtungen X, Y ausgebildet, indem die ersten Markierungen 10 und die zweiten Markierungen 20 jeweils senkrecht zueinander periodisch angeordnet sind.

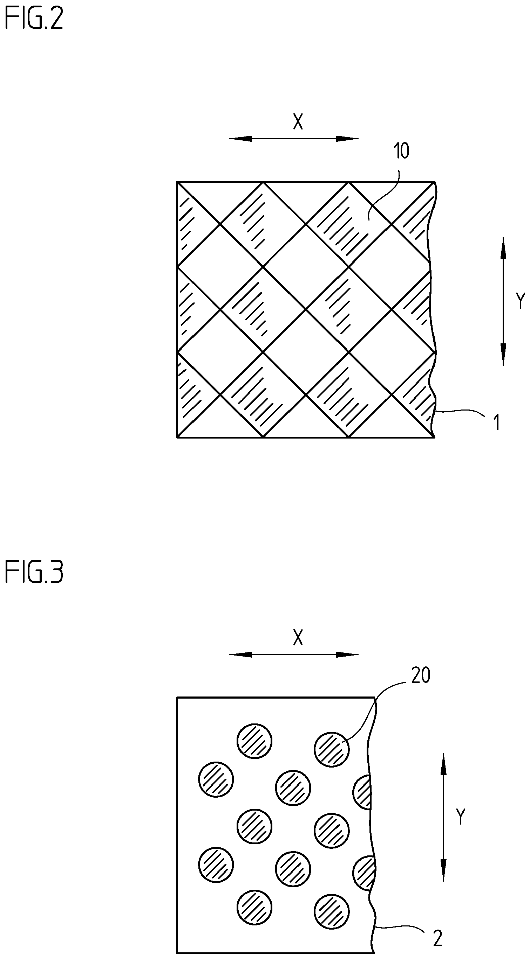

Die Figur 2 zeigt ein Ausführungsbeispiel des ersten Maßstabs 1 in Draufsicht. Die ersten periodischen Markierungen 10 weisen dabei eine rechteckförmige Außenkontur auf.

Die Figur 3 zeigt ein Ausführungsbeispiel eines zweiten Maßstabs 2. Die zweiten Markierungen 20 weisen dabei eine kreisförmige Außenkontur auf. In nicht gezeigter Weise kann die Außenkontur auch eine Ellipse bilden oder die Außenkontur der Markierungen 20 des zweiten Maßstabs 2 ist zusammengesetzt aus Bögen oder ist zusammengesetzt aus Bögen und Geraden.

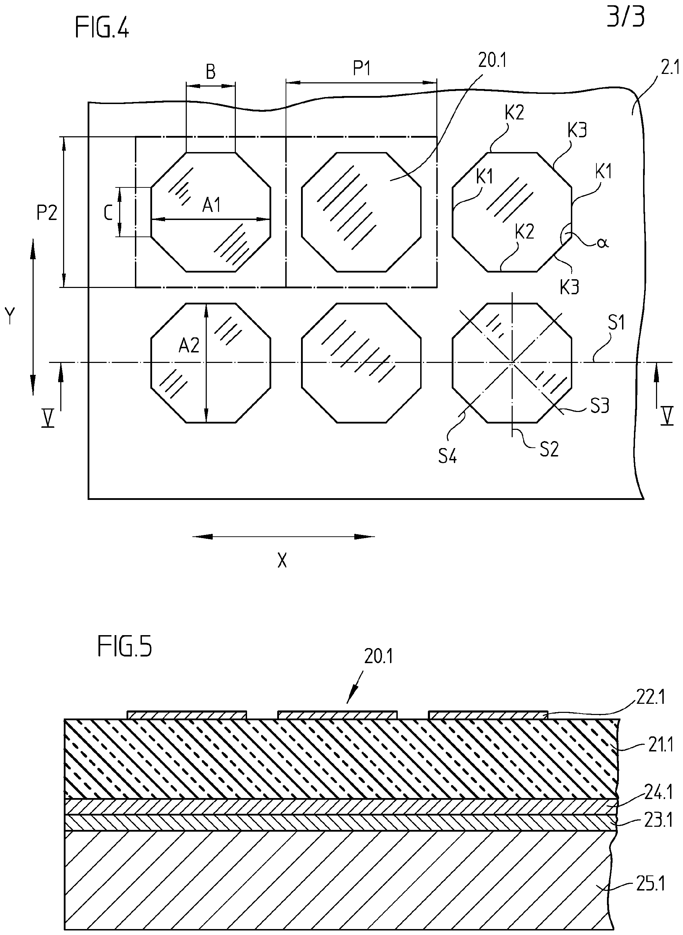

Die Figuren 4 und 5 zeigen eine weitere mögliche Ausgestaltung eines zweiten Maßstabs 2.1 zur Positionsmessung in der ersten Richtung X und in der dazu senkrecht verlaufenden zweiten Richtung Y. Der Maßstab 2.1 umfasst ein Phasengitter mit einer periodischen Anordnung von reflektierenden Markierungen 20.1 in der ersten Richtung X und in der zweiten Richtung Y.

Die Markierungen 20.1 weisen jeweils eine Außenkontur auf, die von einem Linienzug gebildet wird, der zwei einander gegenüberliegende erste gerade Kanten K1 und zwei senkrecht dazu verlaufende einander gegenüberliegende zweite gerade Kanten K2 umfasst sowie Verbindungslinien K3 zwischen jeweils den ersten Kanten K1 und zweiten Kanten K2, welche jeweils einen stumpfen Winkel α einschließen.

Die Verbindungslinien K3 umfassen in vorteilhafter Weise Geraden. Der stumpfe Winkel α zwischen der ersten Kante K1 und der geraden Verbindungslinie K3 sowie der zweiten Kante K2 und der geraden Verbindungslinie K3 beträgt insbesondere jeweils 135°.

Darüber hinaus ist der gegenseitige Abstand A1 der ersten Kanten K1 gleich dem gegenseitigen Abstand A2 der zweiten Kanten K2.

Eine besonders vorteilhafte Ausgestaltung ist eine vierachssymmetrische Außenkontur. Dabei ist die Außenkontur
spiegelsymmetrisch zu einer ersten Symmetrieachse S1, die senkrecht zu den ersten Kanten K1 verläuft, und
spiegelsymmetrisch zu einer zweiten Symmetrieachse S2, die senkrecht zu den zweiten Kanten K2 verläuft, und
spiegelsymmetrisch zu einer dritten Symmetrieachse S3, die 45° zu der ersten Symmetrieachse S1 verläuft, und
spiegelsymmetrisch zu einer vierten Symmetrieachse S4, die senkrecht zu der dritten Symmetrieachse S3 verläuft.

Diese Ausgestaltung hat den Vorteil, dass die Beugungseigenschaften der Markierungen 20.1 in den beiden Richtungen X und Y identisch sind und daher die Abtasteinrichtungen für beide Richtungen X und Y identisch aufgebaut werden können. Es ergeben sich einerseits für beide Richtungen X und Y gleiche räumliche Gegebenheiten, das heißt, dass die Winkel der auszuwertenden Beugungsordnungen gegenüber der X-Y-Ebene identisch sind und die auszuwertenden Beugungsordnungen weisen auch gleiche Intensitäten auf, so dass für beide Richtungen X und Y gleiche Auswerteeinheiten verwendet werden können.

Diese vorteilhaften Bedingungen ergeben sich insbesondere, wenn die ersten Kanten K1 parallel zu einer Richtung Y der beiden Richtungen X, Y und die zweiten Kanten K2 parallel zu der anderen Richtung X der beiden Richtungen X, Y ausgerichtet sind, oder wenn die ersten Kanten K1 45° geneigt zur ersten Richtung X und die zweiten Kanten K2 45° geneigt zur zweiten Richtung Y ausgerichtet sind.

Das Phasengitter ist dazu ausgebildet die nullte Beugungsordnung möglichst vollständig zu unterdrücken. Die Markierungen 20.1 sind mit der Periodizität P1 in der ersten Richtung X angeordnet und mit der Periodizität P2 in der zweiten Richtung Y angeordnet. Für eine präzise und hochauflösende Positionsmessung ist die Periodizität P1 und P2 in vorteilhafter Weise kleiner als 10 um. Weiterhin ist P1 insbesondere gleich P2.

Vorteilhaft ist es, wenn die Länge B der zweiten Kanten K2 jeweils 10 % bis 90% des gegenseitigen Abstandes A1 der ersten Kanten K1 ist, das Verhältnis B/A1 also zwischen 0,1 und 0,9 gewählt wird. Dieses Verhältnis gilt auch für die ersten Kanten K1, so dass die Länge C der ersten Kanten K1 jeweils 10 % bis 90 % des gegenseitigen Abstands A2 der zweiten Kanten K2 ist, das Verhältnis C/A2 also ebenfalls zwischen 0,1 und 0,9 ist.

Eine noch bessere Optimierung ist erreicht, wenn die Länge B der zweiten Kanten K2 jeweils 30 % bis 70 % des gegenseitigen Abstandes A1 der ersten Kanten K1 ist, das Verhältnis B/A1 also zwischen 0,3 und 0,7 gewählt ist, sowie die Länge C der ersten Kanten K1 jeweils 30 % bis 70 % des gegenseitigen Abstandes A2 der zweiten Kanten K2 ist, das Verhältnis C/A2 also zwischen 0,3 und 0,7 gewählt ist.

Figur 5 zeigt einen Schnitt V-V des in Figur 4 dargestellten Maßstabs 2.1.

Der so ausgestaltete Maßstab 2.1 hat eine äußerst hohe relative Beugungseffizienz. Um nun einen derart ausgebildeten Maßstab 2.1 in einer bereits bestehenden Anordnung von Maßstäben als Ersatz verwenden zu können wird erfindungsgemäß die Reflektivität des Maßstabs 2.1 verringert. Diese Verringerung erfolgt in besonderer Weise derart, dass der den Phasenhub erzeugende Schichtstapel unverändert bleibt. Dies wird dadurch erreicht, dass zwischen dem unteren Reflektor 23.1 und der transparenten Abstandsschicht 21.1 eine Dämpfungsschicht 24.1 vorgesehen wird. Diese Dämpfungsschicht 24.1 ist eine teiltransparente Schicht, welche die Reflexion eines auftreffenden Lichtbündels abschwächt, insbesondere um einen Wert zwischen 5 % bis 20%.

Für alle Ausführungsbeispiele gilt, dass die Reflektoren 12, 13, 22, 23, 22.1, 23.1 dünne Schichten sein können, sie können die Materialien Chrom, Gold, Kupfer, Titan, Nickel, Aluminium, Silber oder Silizium enthalten. Als Substrat 15, 25, 25.1 wird vorzugsweise ein Glas, Glaskeramik oder Aluminiumoxidkeramik mit Ausdehnungskoeffizient nahezu Null verwendet, insbesondere ZERODUR, NEXCERA oder ULE.

Als transparente Abstandsschicht 11, 21, 21.1 eignen sich dielektrische Materialien, wie insbesondere SiO₂, TiO₂, Ta₂O₅.

Die Erfindung wurde an Beispielen erläutert, bei denen die gegenüber dem Phasengitter des ersten Maßstabs 1 erhöhte relative Beugungseffizienz des Phasengitters des zweiten Maßstabs 2, 2.1 durch die Form der Außenkontur der Markierungen 20, 20.1 erreicht wird. Die relative Beugungseffektivität des zweiten Phasengitters kann auch erhöht sein durch die Optimierung der Profilform der Phasenstufen, insbesondere des Flankenwinkels. Hierzu wird auf die EP 0 849 567 B1 und die EP1 557 701 B1 verwiesen. Auch hier ist die Erfindung mit Erfolg einsetzbar.

Der Abtaststrahlengang in Figur 1 ist nur schematisch dargestellt. Die erfindungsgemäß ausgestaltete Positionsmesseinrichtung kann vorzugsweise auch derart ausgestaltet sein, dass das Lichtbündel durch mehrmalige Beugung am Maßstab 1, 2, 2.1 positionsabhängig moduliert wird.

## Patentansprüche

1. Positionsmesseinrichtung mit
zumindest einem ersten Maßstab (1) und zumindest einem zweiten Maßstab (2, 2.1), die zur Vergrößerung des Messbereichs aneinander gereiht sind und mit
einer Abtasteinrichtung (4) mit einer Lichtquelle (41) zum Aussenden eines Lichtbündels, wobei der erste Maßstab (1) ein reflektierendes Phasengitter mit ersten periodischen Markierungen (10) aufweist, welche ein auftreffendes Lichtbündel mit einer ersten Beugungseffizienz in eine vorgegebene Beugungsordnung beugt, **dadurch gekennzeichnet, dass**
der zweite Maßstab (2, 2.1) ein reflektierendes Phasengitter mit zweiten periodischen Markierungen (20, 20.1) aufweist, deren Form von den ersten periodischen Markierungen (10) abweicht, und dass die Reflektivität des Phasengitters des zweiten Maßstabs (2, 2.1) gegenüber dem Phasengitter des ersten Maßstabs (1) derart verringert ist, dass es das auftreffende Lichtbündel mit der ersten Beugungseffizienz in die vorgegebene Beugungsordnung beugt.

2. Positionsmesseinrichtung nach Anspruch 1, wobei die Reflektivität des Phasengitters des zweiten Maßstabs (2, 2.1) gegenüber dem Phasengitter des ersten Maßstabs (1) um 5 % bis 20 % verringert ist.

3. Positionsmesseinrichtung nach einem der vorhergehenden Ansprüche, wobei das Phasengitter des ersten Maßstabs (1) und das Phasengitter des zweiten Maßstabs (2, 2.1) jeweils dazu ausgebildet ist, die nullte Beugungsordnung zu unterdrücken.

4. Positionsmesseinrichtung nach einem der vorhergehenden Ansprüche, wobei die vorgegebene Beugungsordnung die erste Beugungsordnung ist.

5. Positionsmesseinrichtung nach einem der vorhergehenden Ansprüche, wobei der erste Maßstab (1) und der zweite Maßstab (2, 2.1) jeweils einen Schichtstapel aufweisen, bestehend aus einer transparenten Abstandsschicht (11, 21, 21.1) und zwei Reflektoren (12, 13, 22, 23, 22.1, 23.1), die zu beiden Seiten der Abstandsschicht (11, 21, 21.1) angeordnet sind, wobei der der Abtasteinrichtung (4) zugewandte Reflektor (12) des ersten Maßstabs (1) die ersten periodischen Markierungen (10) bildet und der der Abtasteinrichtung (4) zugewandte Reflektor (22, 22.1) des zweiten Maßstabs (2, 2.1) die zweiten periodischen Markierungen (20, 20.1) bildet.

6. Positionsmesseinrichtung nach Anspruch 5, wobei die transparente Abstandsschicht (11,21,21.1) aus dielektrischem Material besteht.

7. Positionsmesseinrichtung nach Anspruch 5 oder 6, wobei die Reflektivität des Phasengitters des zweiten Maßstabs gegenüber der Reflektivität des Phasengitters des ersten Maßstabs verringert ist, indem die Reflektivität des Reflektors unter der Abstandsschicht des zweiten Maßstabs kleiner ist als die Reflektivität des Reflektors unter der Abstandsschicht des ersten Maßstabs.

8. Positionsmesseinrichtung nach einem der vorhergehenden Ansprüche 5 oder 6, wobei die Reflektivität des Phasengitters des zweiten Maßstabs (2, 2.1) gegenüber der Reflektivität des Phasengitters des ersten Maßstabs (1) verringert ist, indem zwischen der Abstandsschicht (21, 21.1) und des Reflektors (23, 23.1), welcher unter der Abstandsschicht (21, 21.1) angeordnet ist, eine Dämpfungsschicht (24, 24.1) angeordnet ist.

9. Positionsmesseinrichtung nach Anspruch 8, wobei die Dämpfungsschicht (24, 24.1) eine Dicke von 3 nm bis 15 nm aufweist.

10. Positionsmesseinrichtung nach einem der vorhergehenden Ansprüche, wobei der erste Maßstab (1) und der zweite Maßstab (2, 2.1) jeweils zur Positionsmessung in zwei senkrecht zueinander angeordneten Richtungen (X, Y) ausgebildet ist, indem die ersten Markierungen (10) und die zweiten Markierungen (20, 20.1) in senkrecht zueinander angeordneten Richtungen periodisch angeordnet sind.

11. Positionsmesseinrichtung nach einem der vorhergehenden Ansprüche, wobei die ersten periodischen Markierungen (10) eine Außenkontur aufweisen, die von der Außenkontur der zweiten periodischen Markierungen (20, 20.1) abweicht.

12. Positionsmesseinrichtung nach Anspruch 11, wobei die ersten periodischen Markierungen (10) eine rechteckförmige Außenkontur aufweisen.

13. Positionsmesseinrichtung nach einem der Ansprüche 11 oder 12, wobei die zweiten periodischen Markierungen (20, 20.1) jeweils eine achteckige Außenkontur oder
eine kreisförmige Außenkontur oder
eine Außenkontur zusammengesetzt aus Bögen oder
eine Außenkontur zusammengesetzt aus Bögen und aus Geraden aufweisen oder
eine Außenkontur aufweisen, die von einem Linienzug gebildet wird, der zwei einander gegenüberliegende erste gerade Kanten (K1) und zwei senkrecht dazu verlaufende einander gegenüberliegende zweite gerade Kanten (K2) umfasst sowie Verbindungslinien (K3) zwischen jeweils den ersten Kanten (K1) und den zweiten Kanten (K2), welche jeweils einen stumpfen Winkel (α) einschließen.

## Claims

1. Position measurement device comprising
at least a first scale (1) and at least a second scale (2, 2.1), which are arranged in series in order to increase the measurement range, and comprising
a scanning device (4) comprising a light source (41) for emitting a light beam, wherein the first scale (1) has a reflective phase grid comprising first periodic marks (10), which diffract an incident light beam with a first diffraction efficiency into a predetermined diffraction order, **characterized in that**
the second scale (2, 2.1) has a reflective phase grid comprising second periodic marks (20, 20.1), the shape of which differs from the first periodic marks (10), and that the reflectivity of the phase grid of the second scale (2, 2.1) is reduced as compared to the phase grid of the first scale (1) in such a way that it diffracts the incident light beam into the predetermined diffraction order with the first diffraction efficiency.

2. Position measurement device according to Claim 1, wherein the reflectivity of the phase grid of the second scale (2, 2.1) is reduced by 5% to 20% as compared to the phase grid of the first scale (1).

3. Position measurement device according to one of the preceding claims, wherein the phase grid of the first scale (1) and the phase grid of the second scale (2, 2.1) are in each case embodied to suppress the zeroth diffraction order.

4. Position measurement device according to one of the preceding claims, wherein the predetermined diffraction order is the first diffraction order.

5. Position measurement device according to one of the preceding claims, wherein the first scale (1) and the second scale (2, 2.1) each have a layer stack consisting of a transparent spacer layer (11, 21, 21.1) and two reflectors (12, 13, 22, 23, 22.1, 23.1), which are each arranged on both sides of the spacer layer (11, 21, 21.1), wherein the reflector (12) of the first scale (1), which faces the scanning device (4), forms the first periodic marks (10), and the reflector (22, 22,1) of the second scale (2, 2.1), which faces the scanning device (4), forms the second periodic marks (20, 20.1).

6. Position measurement device according to Claim 5, wherein the transparent spacer layer (11, 21, 21.1) consists of dielectric material.

7. Position measurement device according to Claim 5 or 6, wherein the reflectivity of the phase grid of the second scale is reduced as compared to the reflectivity of the phase grid of the first scale, in that the reflectivity of the reflector under the spacer layer of the second scale is smaller than the reflectivity of the reflector under the spacer layer of the first scale.

8. Position measurement device according to one of the preceding Claims 5 or 6, wherein the reflectivity of the phase grid of the second scale (2, 2.1) is reduced as compared to the reflectivity of the phase grid of the first scale (1), in that an attenuating layer (24, 24.1) is arranged between the spacer layer (21, 21.1) and the reflector (23, 23.1), which is arranged under the spacer layer (21, 21.1).

9. Position measurement device according to Claim 8, wherein the attenuating layer (24, 24.1) has a thickness of between 3 nm and 15 nm.

10. Position measurement device according to one of the preceding claims, wherein the first scale (1) and the second scale (2, 2.1) are in each case embodied for the position measurement in two directions (X, Y), which are arranged perpendicular to one another, in that the first marks (10) and the second marks (20, 20.1) are in each case arranged in a periodic manner in directions, which are arranged perpendicular to one another.

11. Position measurement device according to one of the preceding claims, wherein the first periodic marks (10) have an outer contour, which differs from the outer contour of the second periodic marks (20, 20.1).

12. Position measurement device according to Claim 11, wherein the first periodic marks (10) have a rectangular outer contour.

13. Position measurement device according to one of Claims 11 or 12, wherein the second periodic marks (20, 20.1) in each case have an octagonal outer contour or
a circular outer contour or
an outer contour composed of curves or
an outer contour composed of curves and of straight lines or
have an outer contour, which is formed by a continuous line, which comprises two mutually opposing first straight edges (K1) and two mutually opposing second straight edges (K2) extending perpendicular thereto, as well as connecting lines (K3) in each case between the first edges (K1) and second edges (K2), which each draw an obtuse angle (α).

## Revendications

1. Dispositif de mesure de position comportant au moins une première échelle de mesure (1) et au moins une deuxième échelle de mesure (2, 2.1), qui sont disposées consécutivement pour le grossissement de la région de mesure et comportant
un dispositif de balayage (4) muni d'une source lumineuse (41) destinée à émettre un faisceau lumineux, dans lequel la première échelle de mesure (1) comporte un réseau de phase réfléchissant ayant des premiers marquages périodiques (10), qui diffracte un faisceau lumineux incident avec un premier rendement de diffraction dans une ordre de diffraction prédéterminé, **caractérisé en ce que**
la deuxième échelle de mesure (2, 2.1) comporte un réseau de phase réfléchissant ayant des deuxièmes marquages périodiques (20, 20.1), dont la forme s'écarte de celle des premiers marquages périodiques (10), et **en ce que** la réflectivité du réseau de phase de la deuxième échelle de mesure (2, 2.1) est réduite par rapport au réseau de phase de la première échelle de mesure (1) de manière à ce qu'il diffracte le faisceau lumineux incident avec le premier rendement de diffraction dans l'ordre de diffraction prédéterminé.

2. Dispositif de mesure de position selon la revendication 1, dans lequel la réflectivité du réseau de phase de la deuxième échelle de mesure (2, 2.1) est réduite de 5 % à 20 % par rapport à celle du réseau de phase de la première échelle de mesure (1).

3. Dispositif de mesure de position selon l'une quelconque des revendications précédentes, dans lequel le réseau de phase de la première échelle de mesure (1) et le réseau de phase de la deuxième échelle de mesure (2, 2.1) sont respectivement réalisés de manière à supprimer la diffraction d'ordre zéro.

4. Dispositif de mesure de position selon l'une quelconque des revendications précédentes, dans lequel l'ordre de diffraction prédéterminé est le premier ordre de diffraction.

5. Dispositif de mesure de position selon l'une quelconque des revendications précédentes, dans lequel la première échelle de mesure (1) et la deuxième échelle de mesure (2, 2.1) comportent respectivement un empilement de couches, constitué d'une couche d'espacement transparente (11, 21, 21.1) et de deux réflecteurs (12, 13, 22, 23, 22.1, 23.1), qui sont disposés des deux côtés de la couche d'espacement (11, 21, 21.1), dans lequel le réflecteur (12) de la première échelle de mesure (1), qui est tourné vers le dispositif de balayage (4), forme les premiers marquages périodiques (10) et le réflecteur (22, 22.1) de la deuxième échelle de mesure (2, 2.1), qui est tourné vers le dispositif de balayage (4), forme les deuxièmes marquages périodiques (20, 20.1).

6. Dispositif de mesure de position selon la revendication 5, dans lequel la couche d'espacement transparente (11, 21, 21.1) est constituée de matériau diélectrique.

7. Dispositif de mesure de position selon la revendication 5 ou 6, dans lequel la réflectivité du réseau de phase de la deuxième échelle de mesure est réduite par rapport à la réflectivité du réseau de phase de la première échelle de mesure, en raison du fait que la réflectivité du réflecteur situé sous la couche d'espacement de la deuxième échelle de mesure est inférieure à la réflectivité du réflecteur situé sous la couche d'espacement de la première échelle de mesure.

8. Dispositif de mesure de position selon l'une quelconque des revendications 5 ou 6 précédentes, dans lequel la réflectivité du réseau de phase de la deuxième échelle de mesure (2, 2.1) est réduite par rapport à la réflectivité du réseau de phase de la première échelle de mesure (1) en disposant une couche d'amortissement (24, 24.1) entre la couche d'espacement (21, 21.1) et le réflecteur (23, 23.1) qui est disposé sous de la couche d'espacement (21, 21.1).

9. Dispositif de mesure de position selon la revendication 8, dans lequel la couche d'amortissement (24, 24.1) présente une épaisseur de 3 nm à 15 nm.

10. Dispositif de mesure de position selon l'une quelconque des revendications précédentes, dans lequel la première échelle de mesure (1) et la deuxième échelle de mesure (2, 2.1) sont respectivement réalisées pour une mesure de position effectuée dans deux directions (X, Y) disposées perpendiculairement l'une à l'autre en disposant périodiquement les premiers marquages (10) et les deuxièmes marquages (20, 20.1) dans des directions disposées perpendiculairement l'une à l'autre.

11. Dispositif de mesure de position selon l'une quelconque des revendications précédentes, dans lequel les premiers marquages périodiques (10) présentent un contour extérieur qui s'écarte du contour extérieur des deuxièmes marquages périodiques (20, 20.1).

12. Dispositif de mesure de position selon la revendication 11, dans lequel les premiers marquages périodiques (10) présentent un contour extérieur de forme rectangulaire.

13. Dispositif de mesure de position selon l'une quelconque des revendications 11 ou 12, dans lequel les deuxièmes marquages périodiques (20, 20.1) présentent respectivement un contour extérieur octogonal ou
un contour extérieur circulaire ou
un contour extérieur composé d'arcs ou
un contour extérieur composé d'arcs et de droites ou présentent un contour extérieur formé d'un segment de droite qui comprend deux premières arêtes droites (K1) opposées l'une à l'autre et deux deuxièmes arêtes droites (K2) s'étendant perpendiculairement à celles-ci et opposées l'une à l'autre ainsi que des lignes de jonction (K3) respectives entre les premières arêtes (K1) et les deuxièmes arêtes (K2), qui délimitent respectivement un angle obtus (α).
